(19) **Europäisches Patentamt**
**European Patent Office**
**Office européen des brevets**

(11) **EP 1 791 910 B1**

(12) **EUROPEAN PATENT SPECIFICATION**

(45) Date of publication and mention
of the grant of the patent:
**22.02.2012 Bulletin 2012/08**

(21) Application number: **05768174.4**

(22) Date of filing: **29.06.2005**

(51) Int Cl.:
**C08L 77/06** (2006.01)

(86) International application number:
**PCT/US2005/023645**

(87) International publication number:
**WO 2006/007580 (19.01.2006 Gazette 2006/03)**

(54) **AROMATIC POLYAMIDE COMPOSITION AND ARTICLE MANUFACTURED THEREFROM**

AROMATISCHES POLYAMID ENTHALTENDE ZUSAMMENSETZUNG UND DARAUS HERGESTELLTER GEGENSTAND

COMPOSITION DE POLYAMIDE AROMATIQUE ET ARTICLE FABRIQUÉ À PARTIR DE CELLE-CI

(84) Designated Contracting States:
**AT BE BG CH CY CZ DE DK EE ES FI FR GB GR HU IE IS IT LI LT LU MC NL PL PT RO SE SI SK TR**

(30) Priority: **01.07.2004 US 584134 P**

(43) Date of publication of application:
**06.06.2007 Bulletin 2007/23**

(73) Proprietor: **Solvay Specialty Polymers USA, LLC.**
**Alpharetta, GA 30005 (US)**

(72) Inventors:
• **CROWE, Christie, W.**
**Alpharetta, GA 30005 (US)**

• **SAITO, Masahiko**
**Moriguchi-city,**
**Osaka 570-0015 (JP)**

(74) Representative: **Jacques, Philippe et al**
**Solvay S.A.**
**Département de la Propriété Industrielle**
**Rue de Ransbeek, 310**
**1120 Bruxelles (BE)**

(56) References cited:
**EP-A- 0 410 301    EP-A- 0 585 056**
**EP-A- 1 375 578    WO-A-01/09233**
**WO-A-03/055947**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention concerns a polymer composition which is especially well suited for making reflectors, an article made therefrom, and the use of an optionally functionalized olefin copolymer as an additive of the polymer composition to a specific purpose.

Light Emitting Diode devices (LEDs) are equipments that emit light, generally visible light ; they are often produced by mounting an emitting device on a reflector plate, and sealing it with an epoxy resin or the like. It is usually required for a LED notably to be small, light weight, vibration resistant, of high whiteness and reflectance.

Desirably, reflector plates of LEDs and, in fine, the polymer composition from which they are made should comply with a wide set of requirements, including, notably, high reflectance of light (in general, of visible light), high whiteness, good processability (e.g. good moldability), high dimensional stability (notably low coefficient of linear expansion), high mechanical strength (on account of a possible decrease in reflection performance thereof even for a small distortion), high heat deflection temperature and high heat resistance (low discoloration and low loss of reflectance when exposed to a high temperature e.g. by means of soldering and the like).

Various prior art compositions for reflector plates are described in the background section of EP 1 466 944 A (to Otsuka K.K.). As rightly pointed out by Otsuka, none of them is satisfactory because none of them meets all the above listed requirements ; on the other hand, the compositions invented by Otsuka, as described in EP 1 466 944 A (hereafter Otsuka's compositions), are deemed to meet these requirements.

Certain Otsuka's compositions concern polymer compositions suitable for making reflectors that reflect a particular light, namely ultraviolet (UV) rays originating from a UV generating source; such compositions are based on specific fillers that are capable of reflecting UV rays, like potassium titanate fibers. While Otsuka teaches that titanate fiber-based compositions can also be used for making reflectors that reflect visible light, these ones are, in practice, often disliked for this application for healthy and environmental considerations. Indeed, the morphology of potassium titanate fibers is very similar to the one of asbestos fibers ; they are usually viewed as carcinogenic and drastic precautions are required for their manipulation.

Thus, of more practical interest to the Applicant's opinion, are certain other Otsuka's compositions that are suitable for making reflectors that reflect visible light ; said compositions contain 30 to 95 wt. % by weight of a semi-aromatic polyamide containing at least 20 mol. % of aromatic monomers, and 5 to 70 % by weight of wollastonite. As taught by Otsuka, it is advisable, to further improve the reflectance, to use wollastonite in combination with titanium dioxide.

More precisely, Example 3 of EP.1 466 944 A describes a composition consisting of 50 wt. % of AMODEL® 4000 polyphthalamide, 30 wt. % of wollastonite and 20 wt. % of titanium dioxide. Although much more performing than the compositions presented in the background section of EP 1 466 944 A, in that they meet essentially all the above detailed requirements, this composition and the like are still unsatisfactory for certain applications, especially for reflectors reflecting visible light that are used or are susceptible of being used in outdoor applications. The main reason is that the composition according to Example 3 of Otsuka's patent application and the like exhibit a poor resistance to the UV rays that are contained in the sunlight, especially when concurrently exposed to heat and sunlight, which results in a dramatic loss of the reflectance in the visible spectrum. The problem of maintaining a high level of reflectance after concurrent exposure to heat and UV rays proved to be particularly acute for the range of visible light going from 420 nm to 520 nm. Finding a solution to this problem seems tricky notably because, while titanium dioxide is useful to increase the reflectance, and absorbs UV rays, it might also contribute to promote the degradation of the polymer composition.

Another reason for which the composition according to Example 3 of Otsuka's patent application and the like are still unsatisfactory is that the reflectors made of these prior art compositions have sometimes a lower impact resistance than desired.

Still another reason for which the composition according Example 3 of Otsuka's patent application and the like are still unsatisfactory is that the reflectors made of these prior art compositions have sometimes a surface aspect not as regular as desired.

Thus, it is an objective of the present invention to provide a polymer composition which is especially well suited for manufacturing reflectors, which provides various advantages over prior art polymer compositions, in particular an increased resistance to concurrent exposure to heat and UV rays, while maintaining all the other properties at a high level.

With this end in view, the present invention concerns a polymer composition comprising

- an aromatic polyamide,
- more than 5 wt. % (based on the total weight of the composition) of at least one crystalline silicate chosen from nesosilicates, sorosilicates, cyclosilicates, tectosilicates and inosilicates,
- more than 2 wt. % (based on the total weight of the composition) of titanium dioxide, and
- more than 1 wt. % (based on the total weight of the composition) of at least one optionally functionalized olefin copolymer.

The polymer composition may contain one aromatic polyamide. Alternatively, it may contain several aromatic polyamides.

To the purpose of the present invention, "aromatic polyamide" is intended to denote any polymer comprising more than 50 mole % of aromatic recurring units formed by the polycondensation reaction between at least one diacid and at least one diamine.

The aromaticity of the aromatic recurring units can come from the diacid and/or from the diamine. Non limitative examples of aromatic diacids are phthalic acids and naphthalenedicarboxylic acids. Metaxylylenediamine and paraxylylenediamine are examples of aromatic diamine.

A first class of preferred aromatic polyamides consists of PMXDAs, i.e. aromatic polyamides comprising more than 50 mole % of recurring units formed by the polycondensation reaction between at least one aliphatic diacid and metaxylylenediamine. The aliphatic diacid can be notably adipic acid, sebacic acid or 1,10-decanedioic acid ; adipic acid is preferred. Suitable PMXDAs are notably available as IXEF® PMXDAs from Solvay Advanced Polymers, L.L.C.

A second class of preferred aromatic polyamides consists of polyphthalamides, i.e. aromatic polyamides comprising more than 50 mole % of recurring units formed by the polycondensation reaction between at least one phthalic acid and at least one aliphatic diamine. The phthalic acid can be notably o-phthalic acid, isophthalic acid or terephthalic acid. The aliphatic diamine can be notably hexamethylenediamine, 1,9-nonanediamine, 2-methyl-octanediamine, 2-methyl-1,5-pentanediamine or 1,4-diaminobutane; a $C_6$ diamine, especially hexamethylenediamine, is preferred, except when specified otherwise hereafter. Suitable polyphthalamides are notably available as AMODEL® polyphthalamides from Solvay Advanced Polymers, L.L.C.

Among polyphthalamides, polyterephthalamides are preferred. To the purpose of she present invention, polyterephthalamides are defined as aromatic polyamides comprising more than 50 mole % of recurring units formed by the polycondensation reaction between terephthalic acid and at least one diamine.

A first class of preferred polyterephthalamides consists of polyterephthalamides consisting essentially of recurring units formed by the polycondensation reaction between terephthalic acid and at least one aliphatic diamine [class (I)]. By exception, as concerns the polyterephthalamides of class (I), the preferred diamine is not a $C_6$ diamine, but a $C_9$ diamine, especially 1,9-nonanediamine.

A second class of preferred polyterephthalamides consists of polyterephthalamides consisting essentially of recurring units formed by the polycondensation reaction between terephthalic acid, isophthalic acid and at least one aliphatic diamine [class (II)].

Preferably, the polyterephthalamides of class II consist essentially of recurring units (II-a) formed by the polycondensation reaction between terephthalic acid and at least one aliphatic diamine and of recurring units (II-b) formed by the polycondensation reaction between isophthalic acid and at least one aliphatic diamine, in a mole ratio (II-a):(II-b), expressed in %, ranging between 60:40 and 80:20.

A third class of preferred polyterephthalamides consists of polyterephthalamides consisting essentially of recurring units formed by the polycondensation reaction between terephthalic acid, at least one aliphatic diacid and at least one aliphatic diamine [class (III)]. The aliphatic diacid can be notably adipic acid, sebacic acid or 1,10-decanedioic acid ; adipic acid is preferred.

Preferably, the polyterephthalamides of class III consist essentially of recurring units (III-a) formed by the polycondensation reaction between terephthalic acid and at least one aliphatic diamine and of recurring units (III-b) formed by the polycondensation reaction between at least one aliphatic diacid and at least one aliphatic diamine, in a mole ratio (III-a):(III-b), expressed in %, ranging between 55:45 and 75:25.

A fourth class of preferred polyterephthalamides consists of polyterephthalamides consisting essentially of recurring units formed by the polycondensation reaction between terephthalic acid, isophthalic acid, at least one aliphatic diacid and at least one aliphatic diamine [class (IV)]. The aliphatic diacid can be notably adipic acid, sebacic acid or 1,10-decanedioic acid ; adipic acid is preferred.

Preferably, the polyterephthalamides of class IV consist essentially of recurring units (IV-a) formed by the polycondensation reaction between terephthalic acid and at least one aliphatic diamine, of recurring units (IV-b) formed by the polycondensation reaction between isophthalic acid and at least one aliphatic diamine, and of recurring units (IV-c) formed by the polycondensation reaction between at least one aliphatic diacid and at least one aliphatic diamine, in a mole ratio (IV-a): [(IV-b)+(IV-c)], expressed in %, ranging between 55:45 and 75:25. Besides, for these polyterephthalamides, the mole ratio (IV-b):(IV-c) ranges preferably from 60:40 to 85:15.

The aromatic polyamide is preferably free of recurring units formed by the polycondensation reaction between trimellitic or pyromellitic anhydride and at least one diamine. (polyimide-type recurring units).

The aromatic polyamide is usually semi-crystalline. It has a usually a melting point.

The aromatic polyamide has a melting point advantageously greater than 275 °C, preferably greater than 290°C, more preferably greater than 305°C, and still more preferably greater than 320°C. In addition, the aromatic polyamide has a melting point advantageously of below 350°C, preferably below 340°C and more preferably below 330°C.

The melting point of the aromatic polyamide can be measured by any suitable technique known from the skilled in the art ; very often, it is measured by Differential Scanning Calorimetry. Precisely, Universal V3.7A Instruments DSC calorimeter was used by the Applicant to measure the melting point of the aromatic polyamide. For this purpose, it was preliminarily checked that the calorimeter was well-calibrated by means of a calibration sample. Then, the aromatic polyamide of which the melting point had to be measured was submitted to the following heating/cooling cycle : 1st heating from room temperature up to 350°C at a rate of 10°C/min, followed by cooling from 350°C down to room temperature at a rate of 20°C/min, followed by 2nd heating from room temperature up to 350°C at a rate of 10°C/min. The melting point was measured during 2nd heating. Melting is an endothermic first-order transition that appears as a negative peak on the DSC scan. The melting point is advantageously determined by a construction procedure on the heat flow curve : the intersection of the two lines that are tangent to the peak at the points of inflection on either side of the peak define the peak temperature, namely the melting point.

The aromatic polyamide is contained in the polymer composition in an amount of advantageously more than 30 % by weight, preferably more than 40 % by weight, and still more preferably more than 50 % by weight (based on the total weight of the polymer composition).

Non limitative examples of nesosilicates are olivine $[(Mg,Fe)_2SiO_4]$, forsterite $(Mg_2SiO_4)$, fayalite $(Fe_2SiO_4)$, alite $[Ca_3((SiO_4)O)]$, belite $(Ca_2SiO_4)$, andalousite, sillimanite and kyanite [all three are of formula $Al_2O(SiO_4)$], phenakite, topaz and thaumasite.

Non limitative examples of sorosilicates are prehnite, hemimorphite $[Zn_4(Si_2O_7)(OH)_2]$ and the compound of formula $CaMg(Si_2O_7)$.

Cyclosilicates are silicates with tetrahedrons that usually link to form rings of three $(Si_3O_9)^{-6}$, four $(Si_4O_{12})^{-8}$, six $(Si_6O_{18})^{-12}$ or nine $(Si_9O_{27})^{-18}$ units. Beryl is a cyclosilicate.

Non limitative examples of tectosilicates are quartz, cristobalite, tridymite, orthose $[K(AlSi_3O_8)]$, anorthite $[Ca(Al_2Si_2O_8)]$ and celsiane $[Ba(Al_2Si_2O_8)]$.

Inosilicates have usually a crystalline structure usually in the form of chains. Inosilicates can be subdivided notably in pyroxenes [with a crystalline structure usually in the form of simple chains $(SiO_3)^{-2}$] and amphiboles [with a crystalline structure usually in the form of double chains $(Si_4O_{11})^{-6}$].

Non limitative examples of pyroxenes are diopside $[CaMg(SiO_3)_2]$, spodumene $[LiAl(SiO_3)_2]$, wollastonite $[Ca(SiO_3)]$, enstatite $[Mg(SiO_3)]$, hypersthene, hedenbergite, augite, pectolite, diallage, fassaite, spodumene, jeffersonite, aegirine, omphafacite and hiddenite.

Non limitative examples of amphiboles are calcium amphiboles such as tremolite $[Ca_2Mg_5[Si_4O_{11},(OH,F)]_2]$, actinote $[Ca_2(Mg,Fe)_5[Si_4O_{11},OH]_2]$ and hornblende, iron-magnesium amphiboles such as grunerite and cummingtonite, and sodium amphiboles such as glaucophane, arfvedsonite and riebeckite.

Inosilicates are preferred over other crystalline silicates. Pyroxenes are very preferred.

The crystalline silicate can be further characterized by its elementary formula, e.g. $Zn_4Si_2O_9H_2$ for hemimorphite.

The elementary formula of the crystalline silicate includes advantageously at least one alkaline earth metal. Preferably, the elementary formula includes one or more alkaline earth metal(s), said alkaline earth metal(s) being the sole metal(s) included in the elementary formula. Examples of crystalline silicates of this type are notably $BaSiO_3$ (barium metasilicate), $Ba_2Si_3O_7$ (barium disilicate), $Ba_2SiO_4$ (dibarium silicate), $CaSiO_3$ (monocalcium silicate or wollastonite), $Ca_2SiO_4$ (dicalcium silicate), $Ca_3SiO_5$ (tricalcium silicate), $MgSiO_3$ (enstatite), $Mg_2SiO_4$ (forsterite).

The alkaline earth metal can be notably magnesium, calcium or barium. It is preferably calcium.

Good results were obtained when the crystalline silicate was wollastonite.

To the purpose of the present invention, wollastonite is intended to denote any pyroxene of formula $Ca(SiO_3)$, including β-wollastonite and α-wollastonite (also referred to as pseudo-wollastonite) eniantropes, as well as monoclinic wollastonite and triclinic wollastonite (also referred to as parawollastonite).

Wollastonite is commercially available notably from NYCO as NYAD® or NYGLOS® minerals.

The crystalline silicate can be further characterized by its morphology. With respect thereof, the crystalline silicate consists preferably of acicular particles. The aspect of the particles of the crystalline silicate can be quantified notably by means of their number-average aspect ratio α. α is generally defined as the sum of the individual aspect ratios $\alpha_i$ of the particles (each particle "i" being taken separately) divided by the number of particles. The aspect ratio $\alpha_i$ of a particle "i" is the ratio of the length $L_i$, of the particle divided by its diameter $D_i$.

For convenience, the length of a particle is sometimes defined as the longest dimension of the particle (or, from a more practical point of view, as the longest dimension of the projection of the particle on a photograph, as it appears on said photograph), while the diameter of a particle is possibly defined as the next longest dimension of the particle perpendicular to its length (or, from a more practical point of view, as the longest dimension of the projection of the particle on a photograph, perpendicular to its length) .

However, when an image analysis software is used, it can advantageously be relied upon more complex definitions of for the length and the diameter, which aim at providing a length and a diameter which would e.g. exactly correspond to the effective height and diameter of a cylinder, if a measured particle had a perfect cylindrical shape. As an example thereof, the length of a particle can be defined as the height of the hypothetical cylinder of smallest volume enveloping the particle, while the diameter of a particle can be defined as the diameter of said hypothetical cylinder ("method of the cylindrical envelope"). In practice, when a photograph is used, the projection of the particle on the photograph is accounted for instead of the particle itself ; the hypothetical cylinder of smallest volume is replaced by the hypothetical rectangle of smallest surface enveloping the projection of the particle, and the length and the width of said hypothetical rectangle are defined as the length and the diameter of the particle ("method of the rectangular envelope"). When the particles are acicular, it is generally easy for the skilled person to determine the rectangle of smallest surface just by visual inspection ; then, the method of the rectangular envelope can be applied by setting the image analysis software in "manual mode", as detailed below.

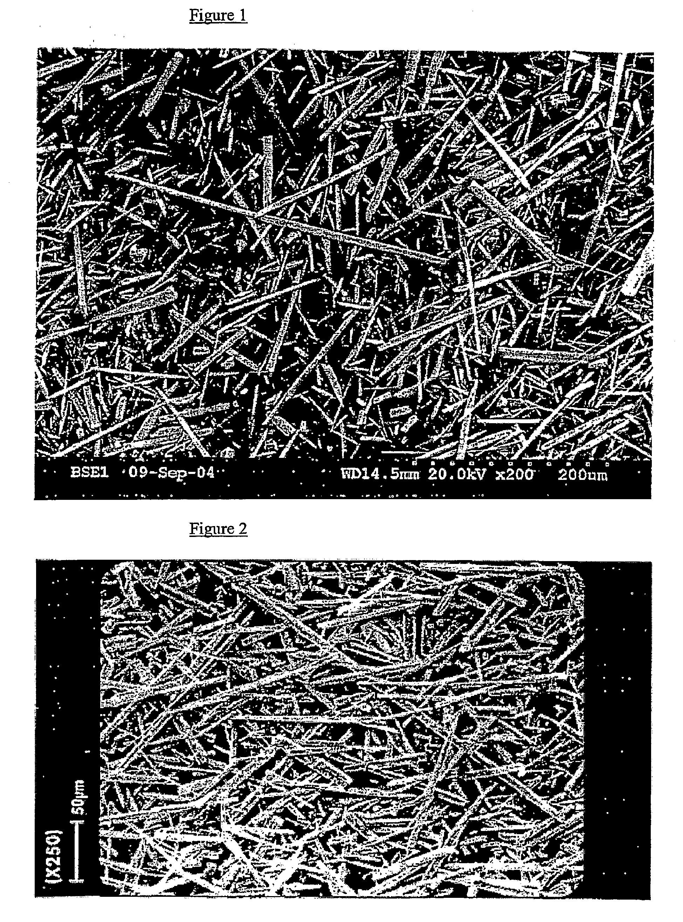

The number-average aspect ratio of the particles of the crystalline silicate was advantageously determined by Scanning Electron Microscopy (SEM) coupled with an image analysis software. Accordingly, the crystalline silicate particles were dispersed on aluminum stubs with a double sided carbon adhesive tape. A thin layer of gold-palladium was applied on the particles to increase their electronic conductivity. The particles were then observed with a S-4300 Field Emission Scanning Electron Microscope (FESEM) from HITACHI, using backscattered electron imaging (BSE) to increase the atomic contrast [the image settings were chosen so as to obtain the widest spectrum of gray values (histogram stretch)] ; the working distance was 14.5 mm, the acceleration voltage was 20.0 kV and the magnification was 200 times. Micrographs of each sample were obtained, as e.g. in Figure 1. The length and the diameter of each particle taken individually were measured using QUARTZ PCI (version 5.1) image analysis software from SCIENTIFIC IMAGE MANAGEMENT SYSTEM. The software was prealably calibrated using a MRS3-XYZ R14-133 NIST traceable certified standard from GELLER MICROANALYTICAL LABORARORY. The software was advantageously used in "manual" mode (i.e. with no automatic shape recognition and measurement) ; accordingly, the characteristic dimensions of each particle (length and width, e.g. as defined per the "method of the rectangular envelope") were measured individually by clicking successively on the extremities of the characteristic dimensions ; then, for each characteristic dimension of each particle, the software calculated a number of pixels, that was converted into microns. Only the particles entirely visible in the field of view were measured ; particles touching the edge of the field of view were discarded. Particles crossing each other were measured individually; if only one "half" of one of the particles that cross each other was visible, this particle was not measured. A high number of measurements was made (well above 100 and, preferably, more than 1000), so as to get representative data. The results were then imported in Microsoft EXCEL and statistical data were calculated.

The crystalline silicate consists of particles having a number-average aspect ratio $\alpha$ ranging generally between 2.5 and 250. $\alpha$ is preferably above 5, more preferably above 10, and still more preferably at least 15. In addition, $\alpha$ is preferably below 50, more preferably below 30 and still more preferably at most 25.

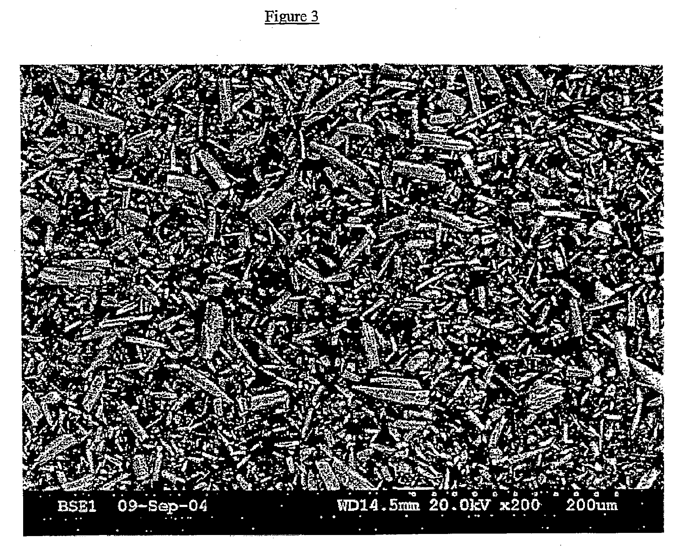

Excellent results were obtained when the crystalline silicate was NYGLOS® 8 wollastonite. Figures 1 and 2 are photographs of NYGLOS® 8 wollastonite particles. Per NYCO's technical documentation, NYGLOS® 8 wollastonite has an aspect ratio $\alpha$ of 19. On the other hand, Figure 3 is a photograph of NYAD® 400 wollastonite particles, also manufactured by NYCO. NYAD® 400 wollastonite provided less good results than NYGLOS® 8 wollastonite ; NYAD® 400 wollastonite is reported to have an aspect ratio $\alpha$ of below 5. Thus, in particular but not only when the crystalline silicate is wollastonite, the crystalline silicate consists preferably of particles having a number-average aspect ratio substantially greater than the the one of the particles of Figure 3, and, more preferably, it consist of particles having a number-average aspect ratio substantially equal to the one of the particles of Figures 1 and 2, as visually assessed by the skilled person.

Benefits from using crystalline silicates having an aspect ratio in the preferred specified ranges lie usually in a higher tensile strength, tensile modulus and heat deflection temperature (when compared to using crystalline silicates with an aspect ratio lower than desired), in an improved processability and in a better surface aspect (when compared to using crystalline silicates having an aspect ratio higher than desired).

The crystalline silicate can be further characterized by its color. With respect thereof, the crystalline silicate has advantageously an at least whitish aspect. Preferably, it has a white aspect. From a quantitative point of view, the GE whiteness, measured according to ASTM E97, of the crystalline silicate is preferably above 82, more preferably above 86, and still more preferably above 88.

The crystalline silicate is contained in the polymer composition in an amount of preferably more than 10 % by weight, and very preferably more than 15 % by weight (based on the total weight of the polymer composition). Besides, the crystalline silicate is contained in the polymer composition in an amount of advantageously less than 40 % by weight, preferably less than 30 % by weight, and very preferably less than 25 % by weight (based on the total weight of the polymer composition).

The optionally functionalized olefin copolymer is a copolymer under the common sense of the term, i.e. it comprises recurring units are derived from at least two monomers ; examples of copolymers include random copolymers, block copolymers, grafted copolymers, and copolymers obtained by combining the techniques of random copolymerization, block copolymerization and/or grafting. It is preferably chosen from optionally grafted random copolymers and optionally grafted block copolymers.

The optionally functionalized olefin copolymer has the nature of an olefin in that it comprises more than 90 wt. %, and preferably more than 95 wt. %, of recurring units derived from an olefm. As it appears clearly from the chemical nature of the various polymers that are hereafter cited as examples of optionally functionalized olefin copolymers suitable for the purpose of the present invention, the wording "derived from an olefin" as herein used should be understood as "derived from at least one olefin".

An olefin is herein intended to denote a mono- or polyethylenically unsaturated compound consisting of carbon and hydrogen atoms. Olefins can be notably chosen from the group of acyclic monoolefins, acyclic diolefins, cyclic monoolefins, cyclic diolefins, aromatic monoolefins and aromatic diolefins. Examples of acyclic monoolefins include ethylene, propylene, 1-butene, isobutene, 2-butene, 1-pentene, 1-hexene, 1=heptene, 1-octene, 1-decene, 1-dodecene, isomers thereof. Examples of acyclic diolefins include butadienes like 1,3-butadiene and 1,4-butadiene, $\alpha$-$\omega$-hexadiene, $\alpha$-$\omega$-octadiene, $\alpha$-$\omega$-decadiene, $\alpha$-$\omega$-dodecadiene, and isomers thereof. Examples of cyclic monoolefins include cyclobutene, cyclopentene, cyclohexene and norbornene. Examples of cyclic diolefins include dicyclopentadiene, ethylidene norbornene and norbornadiene. Examples of aromatic monoolefins include styrene, alkyl substituted styrene such as $\alpha$-methylstyrene. Preferred olefins are chosen from the group of ethylene, propylene, butadienes and styrene. Optionally, the recurring units derived from butadienes may optionally undergo a hydrogenation step subsequent to their polymerization, so as to be partially or fully converted into butylene recurring units.

The optionally functionalized olefin copolymer may optionally further comprise less than 10 wt. %, and preferably less than 5 wt. %, of recurring units derived from a monomer other than an olefin. Examples of monomers other than an olefin include acrylic acid, methacrylic acid, esters of acrylic acid (e.g. methyl acrylate or n-butyl acrylate), esters of methacrylic acid (e.g. methyl methacrylate or n-butyl methacrylate), acrylonitrile, methacrylonitrile, acrylamide, methacrylamide, unsaturated dicarboxylic acids such as maleic acid or fumaric acid, esters of dicarboxylic unsaturated acids, anhydrides of unsaturated dicarboxylic acids (e.g. maleic anhydride or succinic anhydride), epoxy compounds (e.g. glycidyl acrylate and glycidyl methacrylate), vinyl acetate, halogenated vinyl monomers (e.g. vinyl chloride, vinylidene fluoride, hexafluoropropylene, tetrafluoroethylene, chlorotrifluoroethylene and perfluorovinylethers).

In some instances, the optionally functionalized olefm copolymer may be derived from one olefin and at least one monomer other than an olefin. Examples of such copolymers include ethylene-(meth)acrylic acid copolymers and their alkali (like sodium) or alkaline-earth (link zinc) metal salts. More often and in a preferred manner, the optionally functionalized olefin copolymer is either derived from at least two olefins, or from at least two olefins and at least one monomer other than an olefin.

The optionally functionalized olefin copolymer can have one or several distinct glass transition temperatures. Non limitative examples of optionally functionalized olefin copolymers that may have several distinct glass transition temperatures are : (i) optionally functionalized olefin block copolymers comprising recurring units derived from styrene and recurring units derived from at least one monoolefin (commonly known as "optionally functionalized styrene-monoolefins block copolymers") such as optionally maleic anhydride-grafted SEBS, SEB, SEPS and SEP (where S is for styrene, E is for ethylene, P is for propylene and B is for butylene obtained by the hydrogenation of recurring units derived from butadiene) and (ii) optionally functionalized block copolymers comprising recurring units derived from styrene and non hydrogenated recurring units derived from at least one diolefin (commonly known as "optionally functionalized styrene-diolefins block copolymers") such as optionally maleic anhydride-grafted S$\beta$, S$\beta$S, SIS and A$\beta$S (where S is for styrene, $\beta$ is for butadiene, I is for isoprene and A is for acrylonitrile). All the above cited optionally functionalized olefin copolymers should herein be considered as specifically disclosed in their unfunctionalized form as well as in their maleic anhydride grafted form.

The optionally functionalized olefin copolymer has preferably at least one glass transition temperature (measured by DSC during the second heat with a slope of 10°C/min, as detailed in the next paragraph) lower than - 10 °C, more preferably lower than - 20 °C and still more preferably lower than -30°C ; besides, it has preferably its glass transition temperature(s) which is (or are all) above -65 °C.

The glass transition temperature(s) of the optionally functionalized olefin copolymer is (are) measured by Differential Scanning Calorimetry (DSC). For example, a Mettler DSC 30 calorimeter can be used. Advantageously, it is preliminarily checked that the calorimeter is well-calibrated by means of a calibration sample. Then, the optionally functionalized olefin copolymer is submitted to the following cooling/heating cycle : 1st cooling from room temperature down to -100°C at a rate of 20°C/min, followed by 1st heating from -100°C up to +100°C at a rate of 10°C/min, followed by 2nd cooling from +100°C down to -100°C at a rate of 20°C/min, followed by 2nd heating from -100°C up to +100°C at a rate of 10°C/min. The glass transition temperature is measured during the 2nd heating. The glass transition temperature is advantageously determined by a construction procedure on the heat flow curve : a first tangent line to the curve above the transition region is constructed ; a second tangent line to the curve below the transition region is also constructed ; the temperature on the curve halfway between the two tangent lines, or ½ delta Cp, is the glass transition temperature.

The optionally functionalized olefin copolymer is advantageously rubbery.

The optionally functionalized olefin copolymer is preferably functionalized. More preferably, it is functionalized by carboxyl groups. Still more preferably, it comprises from at least 0.1 wt. % up to 5 wt. % of carboxyl groups.

Functionalisation can be achieved notably by grafting and/or by random- or block-copolymerizing at least one ethylenically unsaturated functional monomer. Functionalisation is preferably achieved by grafting.

The functional monomer is preferably one bearing carboxyl groups such as maleic anhydride, methacrylic acid, or acrylic acid and their alkali (like sodium) or alkaline-earth (link zinc) metal salts, as well as (meth)acrylic acid ester (s). More preferably, the functional monomer is maleic anhydride. Should the optionally functionalized olefin copolymer contain carboxylic acid groups, these ones can be partially or totally neutralized by an alkaline or alkaline-earth hydroxide or salt subsequent to the copolymerization or the grafting step. Suitable functionalized olefin copolymers are available from various commercial sources, notably :

- ethylene-propylene copolymer rubbers comprising pendant succinic anhydride groups available as EXXELOR® VA from the Exxon Mobil Chemical Company, such as EXXELOR® VA 1801,
- maleic anhydride-grafted styrene / ethylene-butylene / styrene block copolymers rubbers available as KRATON® FG from Kraton Polymers, such as KRATON® FG1901X,
- maleic anhydride-functionalized ethylene-propylene-diene terpolymer rubbers (EPDM), such as ROYALTUF® 498, a 1 % maleic anhydride grafted EPDM, available from the Crompton Corporation.

Optionally functionalized olefin copolymers suitable for use in certain embodiments of the present invention comprise recurring units derived from ethylene. Preferably, they comprise recurring units derived from ethylene and at least one other olefin chosen from $C_3$-$C_{12}$ monoolefins (like propylene, 1-butene and 1-hexene) and diolefins (like isoprene, 1,3-butadiene, 1,4-butadiene, 1,4- hexadiene, 1,5-hexadiene, cyclohexadiene, cyclooctadiene and allcenylnorbornenes). More preferably, they comprise recurring units derived from ethylene and at least one $C_3$-$C_{12}$ monoolefin. Still more preferably, they comprise, as sole recurring units, either (i) recurring units derived from ethylene and at least one $C_3$-$C_{12}$ monoolefin, and, optionally in addition, pendant recurring units derived from at least one ethylenically unsaturated functional monomer bearing carboxyl groups, or (ii) recurring units derived from ethylene, at least one $C_3$-$C_{12}$ monoolefin and at least one diolefin, and, optionally in addition, pendant recurring units derived from at least one ethylenically unsaturated functional monomer bearing carboxyl groups.

Optionally functionalized olefin copolymers suitable for use in certain embodiments of the present invention comprise recurring units derived from styrene, in an amount of :

- preferably above 5 wt. %, more preferably above 10 wt. %, and still more preferably above 20 wt. % (based on the total weight of the copolymer), and
- preferably below 60 wt. %, more preferably below 50 wt. %, and still more preferably below 40 wt. % (based on the total weight of the copolymer).

Preferably, they comprise recurring units derived from styrene and at least one other olefin chosen from diolefins (like 1,3-butadiene, 1,4-butadiene, 1,4-hexadiene, 1,5-hexadiene, cyclohexadiene, cyclooctadiene and alkenylnor-bornenes) and $C_2$-$C_{12}$ monoolefins (like ethylene, propylene, 1-butene and 1-hexene). More preferably, they comprise recurring units derived from styrene and at least one diolefin. Still more preferably, they comprise, as sole recurring units, either (i) recurring units derived from styrene and at least one diolefin, and, optionally in addition, pendant recurring units derived from at least one ethylenically unsaturated functional monomer bearing carboxyl groups, or (ii) recurring units derived from styrene, at least one diolefin and at least one $C_2$-$C_{12}$ monoolefin, and, optionally in addition, pendant recurring units derived from at least one ethylenically unsaturated functional monomer bearing carboxyl groups. In the above copolymers, the recurring units derived from the diolefin may non hydrogenated, partly hydrogenated or fully hydrogenated. The most preferably, the optionally functionalized olefin copolymers comprise, as sole recurring units, recurring units derived from styrene, at least one diolefin, at least one $C_2$-$C_{12}$ monoolefin and, optionally in addition, pendant recurring units derived from at least one ethylenically unsaturated functional monomer bearing carboxyl groups, wherein the recurring units derived from the diolefin are partly hydrogenated or fully hydrogenated. Excellent results were obtained with KRATON® FG1901X, a 1 % maleic anhydride grafted styrene / ethylene-butylene / styrene block copolymer comprising about 30 wt. % of polystyrene blocks available from Kraton Polymers.

The optionally functionalized olefin copolymer for preparing the polymer composition according to the instant invention is not limited the above cited optionally functionalized olefin copolymers.

The optionally functionalized olefin copolymer is contained in the polymer composition in an amount of preferably more than 2 % by weight, more preferably more than 3 % by weight, and still more preferably more than 6 % by weight (based on the total weight of the polymer composition). Besides, the optionally functionalized olefin copolymer is contained in the polymer composition in an amount of advantageously less than 35 % by weight, preferably less than 20 % by weight, more preferably less than 15 % by weight and still more preferably less than 12 % by weight (based on the total weight of the polymer composition).

The titanium dioxide is advantageously in the form of particles having a weight-average size (equivalent diameter) preferably of below 5 $\mu$m, because higher sizes may deleteriously affect the properties of the composition. Preferably, the weight-average size of the particles is of below 1 $\mu$m. Besides, it is preferably of above 0.1 $\mu$m. The shape of the particles is not particularly limited ; they may be notably round, flaky, flat and so on.

The titanium dioxide used in the instant compositions is commercially available. Titanium dioxide is not particularly limited, and a variety of crystalline forms such as the anatase form, the rutile form and the monoclinic type can be used. However, the rutile form is preferred due its higher refreaction index and its superior light stability. Titanium dioxide may be treated or not with a surface treatment agent.

Preferably, the polymer composition comprises above 4 wt. % (based on the total weight of the polymer composition) of the titanium dioxide. Still more preferably, the polymer composition comprises above 6 wt. % (based on the total weight of the polymer composition) of the titanium dioxide. The most preferably, the polymer composition comprises above 8 wt. % (based on the total weight of the polymer composition) of the titanium dioxide.

Besides, the polymer composition comprises advantageously less than 50 wt. %, preferably less than 25 wt. %, and still more preferably less than 15 wt. % (based on the total weight of the polymer composition) of titanium dioxide.

In a preferred embodiment, the polymer composition further comprises more than 0.003 wt. % (based on the total weight of the composition) of at least one optical brightener.

Optical brighteners are notably commercially available as EASTOBRITE® additives from Eastman Chemicals. The optical brightener is preferably from benzoxazole derivatives. Still more preferably, the optical brightener is 4,4'-bis (2-benzoxazolyl)stilbene.

More preferably, the polymer composition comprises above 0.010 wt. % (based on the total weight of the polymer composition) of the optical brightener. Still more preferably, the polymer composition comprises above 0.020 wt. % (based on the total weight of the polymer composition) of the optical brightener.

Besides, the polymer composition comprises advantageously less than 1.00 wt. %, preferably less than 0.25 wt. %, and still more preferably less than 0.10 wt. % (based on the total weight of the polymer composition) of the optical brightener.

The polymer composition can optionally comprise additional components, notably mold release agents, plasticizers, lubricants, thermal stabilizers, light stabilizers, antioxidants and fillers other than the above described crystalline silicates, especially glass fiber.

The levels of these optional additives will be determined for the particular use envisioned, with generally up to 50 wt. %, preferably up to 20 wt. %, more preferably up to 10 wt. % and still more preferably up to 5 wt. % (based on the total weight of the polymer composition) of such additional additives considered to be within the range of ordinary practice in the extrusion art.

In a particular embodiment of the polymer composition as above detailed, the component consisting of more than 2 wt. % (based on the total weight of the composition) of titanium dioxide, can be replaced by a component consisting of more than 0.003 wt. % (based on the total weight of the composition) of at least one optical brightener.

In this particular embodiment, the polymer composition comprises thus

- an aromatic polyamide,
- more than 5 wt. % (based on the total weight of the composition) of at least one crystalline silicate chosen from nesosilicates, sorosilicates, cyclosilicates, tectosilicates and inosilicates,
- more than 0.003 wt. % (based on the total weight of the composition) of at least one optical brightener, and more than 1 wt. % (based on the total weight of the composition) of at least one optionally functionalized olefin copolymer.

It is another objective of the present invention to provide an article, in particular a reflectors and a LED containing a reflector, which provides various advantages over prior art articles, in particular an increased resistance to concurrent exposure to heat and UV rays, while maintaining all the other properties at a high level.

With this end in view, the present invention concerns an article comprising the polymer composition as above described, in all its embodiments.

Non limitative examples of articles according to the present invention include electric components, electrical housings, telecommunication components, electronic components and electro-optical components such as light-emitting electro-chemical cells and electro-optical components comprising at least one semi-conductor chip that emits and/or transmits electromagnetic radiation, commonly known as light-emitting diode devices (in short, "light-emitting diodes" or "LEDs").

The article is preferably an electro-optical component.

More preferably, the article is an electro-optical component that emits light (hereafter "light emission apparatus"). Non limitative examples of light emission apparatuses are keyless entry systems of a automobile, lightings in a refrigerator, liquid crystal display apparatuses, automobile front panel lighting apparatuses, desk lamps, headlights, household electrical appliance indicators and outdoor display apparatuses such as traffic signs, and LEDs.

Still more preferably, the article is a LED.

The LED comprises usually at least one part comprising the polymer composition as above described.

Preferably, more than 50 wt. % of the part comprises the polymer composition (the part can possibly further contain notably a metal ; for example, the inner walls of the part may be metal plated). More preferably, more than 90 wt. % of the part comprises the polymer composition. Still more preferably, the part consists essentially of the polymer composition. The most preferably, the part consists of the polymer composition.

The part is preferably chosen from basic housings and heatsink slugs.

The part acts usually as reflector.

LEDs are preferably chosen from the group of top view LEDs, side view LEDs and power LEDs. Top view and side view LEDs comprise usually a basic housing, which, in general, acts as a reflector; besides, top view and side view LEDs usually do not comprise any heatsink slug. On the other hand, power LEDs comprise usually a heatsink slug, which, in general, acts as reflector; power LEDs usually further comprise a basic housing, which is a part distinct from the heatsink slug.

The top view LEDs are notably used in automotive lighting applications such as instrumental panel displays, stop lights and turn signals. The side view LEDs are notably used for mobile appliance applications such as, for example, cell phones and PDAs. The power LEDs are notably used in flashlights, automotive day light running lights, signs and as backlight for LCD displays and TVs.

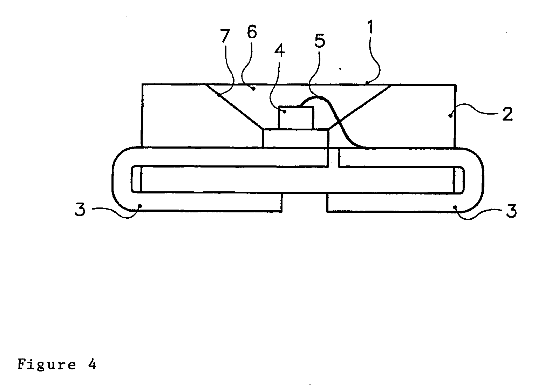

An embodiment of a top view LED is provided in Figure 4, which illustrates a sectional view of said embodiment. The top view LED (1) comprises a basic housing (2) comprising the polymer composition. As will be detailed hereafter, the basic housing (2) acts also as reflector. No heatsink slug is present.

The LED (1) further comprises an electrical lead frame (3). The lead frame (3) is encapsulated, advantageously by injection molding, with the polymer composition comprised in the basic housing (2) ; the lead frame (3) has terminals.

The basic housing (2) presents a cavity (6). A semiconductor chip (4) that emits electromagnetic radiations, such as a LED chip, is mounted inside the cavity. The semiconductor chip (4) is generally bonded and electrically contact-connected on a lead frame terminal by means of a bonding wire (5).

A transparent or translucent potting compound (e.g. an epoxy, a polycarbonate or a silicone resin, not shown in Figure 4) is generally built into the cavity in order to protect the LED chip (4).

It is customary, for the purpose of increasing the external efficiency of the LED chip (4), to shape the cavity (6) of the basic housing (2) with non perpendicular inner areas in such a way that the cavity acquires a form opening towards the front side (the sectional view of the inner wall of the cavity may have, for instance, the form of an oblique straight line, as in the exemplary embodiment in accordance with Figure 4, or that of a parabola).

Thus, the inner walls (7) of the cavity (6) of the basic housing (2) serve as reflector for the radiation which is emitted laterally by the semiconductor chip (4), notably reflecting this radiation towards the front side of the basic housing (2).

It goes without saying that the number of chips which can be mounted in the cavity of the basic housing, as well as the number of cavities which can be formed inside a basic housing, is not restricted to one.

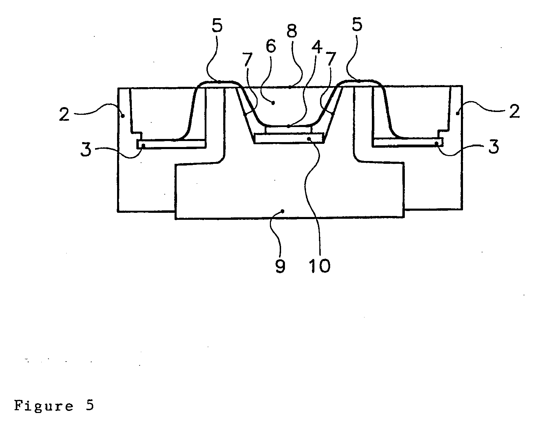

An embodiment of a power LED is provided in Figure 5, which illustrates a sectional view of said embodiment. The power LED (8) comprises a basic housing (2) comprising the polymer composition.

The LED (8) further comprises an electrical lead frame (3), which has electric terminals.

The power LED (8) also comprises a carrier body or heatsink slug (9) which may be of metal (e.g. aluminum) or which may comprise the polymer composition. A cavity (6) is realized in the upper portion of the heatsink slug (9).

A semiconductor LED chip (4) that emits electromagnetic radiations is mounted on the bottom area of cavity (6) and it is generally fixed by means of a chip carrier substrate or solder connection (10) to the heatsink slug (9). The solder connection (10) is generally an epoxy resin or another equivalent adhesive material.

The LED chip (4) is generally conductively connected to the electric terminals of the lead frame (3) via the bonding wires (5).

The inner walls (7) of the cavity (6) run advantageously from the bottom area of the cavity to the front side so as to form a reflector increasing the external efficiency of the LED chip (4). The inner walls (7) of the reflector may be, for example, straight and oblique (like in the exemplary embodiment in accordance with Figure 5) or concavely curved.

The lead frame (3) and the heatsink slug (9) are encapsulated within the basic housing (2). In order to protect the LED chip (4), the cavity is generally completely filled, likewise in the previously detailed embodiment, with a radiation-transmissive, for example transparent, encapsulation compound (the encapsulent is not shown in Figure 5).

The invented polymer composition is particularly suitable for making basic housings and/or heatsink slugs as above described, because, besides having excellent thermal conductivity thus allowing the heat produced by the optoelectronic device to be easily dissipated, it has also good mechanical properties, high heat deflection temperature, good plateability, good adhesion to lead frame, excellent optical properties, notably excellent initial whiteness and high retention of reflectance.

The optical properties of the polymer composition are generally largely enough for the purpose of obtaining reflectors whose inner walls have excellent reflectance.

Thus, another aspect of the present invention is to a part susceptible of acting as a reflector in a light emission apparatus, especially in a LED, said part comprising the polymer composition as above described. Preferably, more than 50 wt. % of the part comprises the polymer composition (the part can possibly further contain notably a metal ; for example, the inner walls of the part may be metal plated). More preferably, more than 90 wit. % of the part comprises the polymer composition. Still more preferably, the part consists essentially of the polymer composition. The most preferably, the part consists of the polymer composition.

Preferably, the part is susceptible of constituting the basic housing and/or the heatsink slug of a LED. More preferably, the part is either the basic housing of a LED or the heatsink slug of a LED.

The composition and the article according to the present invention exhibit a high resistance to exposure to UV rays, in particular a high resistance to concurrent exposure to heat and UV rays, said UV resistance being considerably increased when compared to prior art compositions and articles which are free of optionally functionalized olefin copolymer, in particular the wollastonite-filled $TiO_2$-pigmented polyphthalamide composition of Example 3 of EP 1 466 944 to Otsuka. The superiority of the invented composition and article is particularly high for the range of visible light going from 420 nm to 520 nm. Thus, the invented composition and article are particularly well suited for outdoor applications.

Thus, another aspect of the present invention concerns the use of at least one optionally functionalized olefin copolymer as an additive of a polymer composition comprising an aromatic polyamide to increase the UV resistance of the polymer composition.

Related other aspects of the present invention concern :

- the use of at least one optionally functionalized olefin copolymer as an additive of a polymer composition comprising an aromatic polyamide to increase the UV resistance of an article comprising the polymer composition ; and
- the use of at least one optionally functionalized olefin copolymer as an additive of a polymer composition comprising an aromatic polyamide to increase the UV resistance of a part susceptible of acting as a reflector in a light emission apparatus, especially in a LED, said part comprising the polymer composition.

In the invented uses, the optionally functionalized olefin copolymer is preferably used to increase the resistance of the polymer composition to a concurrent exposure to heat and UV rays.

In the invented uses, the polymer composition complies advantageously with part of, and preferably with all, the essential characteristics of the invented polymer composition as above described wherein the titanium dioxide can be replaced by at least one white pigment. Thus, as concerns the presently invented uses :

- the optionally functionalized copolymer is advantageously used in an amount of more than 1 wt. % (based on the total weight of composition, including thus the weight of the optionally functionalized copolymer itself ;
- advantageously too, the polymer composition further comprises more than 5 wt. % (based on the total weight of the composition) of at least one crystalline silicate chosen from nesosilicates, sorosilicates, cyclosilicates, tectosilicates and inosilicates ;
- advantageously too, the polymer composition further comprises more than 2 wt. % (based on the total weight of the composition) of at least one white pigment, and/or more than 0.003 wt. % (based on the total weight of the composition) of at least one optical brightener.

In the invented uses, the polymer composition complies also preferably with part of, and preferably all, the preferred characteristics of the invented polymer composition as above described wherein the titanium dioxide can be replaced by at least one white pigment.

Non limitative examples of white pigments include zinc disulfide ($ZnS_2$), zinc oxide (ZnO) and titanium dioxide.

The white pigment is advantageously in the form of particles having a weight-average size (equivalent diameter) preferably of below 5 $\mu$m, because higher sizes may deleteriously affect the properties of the composition. Preferably, the weight-average size of the particles is of below 1 $\mu$m. Besides, it is preferably of above 0.1 $\mu$m. The shape of the particles is not particularly limited ; they may be notably round, flaky, flat and so on.

The white pigment is preferably titanium dioxide.

Preferably, the polymer composition comprises above 4 wt. % (based on the total weight of the polymer composition) of the white pigment. Still more preferably, the polymer composition comprises above 6 wt. % (based on the total weight of the polymer composition) of the white pigment. The most preferably, the polymer composition comprises above 8 wt. % (based on the total weight of the polymer composition) of the white pigment.

Besides, the polymer composition comprises advantageously less than 50 wt. %, preferably less than 25 wt. %, and still more preferably less than 15 wt. % (based on the total weight of the polymer composition) of white pigment.

Other advantages of the invented polymer composition and article lie in their increased impact resistance, and, sometimes too, in a more regular surface aspect.

Meanwhile, the invented composition and article maintain all the properties that are desired in LED reflector applications at a high level, including notably a high reflectance of light, a high whiteness, a good processability, a high dimensional stability (notably low coefficient of linear expansion), a high mechanical strength, a high heat deflection temperature and a high heat resistance.

Preparation of compositions.

Examples E1 and E2 (compositions according to the invention).

A polyterephthalamide resin of class (I) commercially available from SOLVAY ADVANCED POLYMERS as AMODEL® polyphthalamide, a rutile titanium dioxide commercially available from DU PONT, KRATON® FG1901X olefin copolymer, a lube, an optical brightener commercially available from EASTMAN as EASTOBRITE® additive, as well as an antioxidant and a heat stabilizer were physically blended in a vessel (drum tumbled) until a homogeneous mixture was obtained, in the weight ratios specified in table 1 below.

Then, the blended mixture was fed to the first barrel of a Berstorff ZE-25 twin screw extruder comprising 8 barrels via a loss in weight feeder. The mixture was melted, reacted and dispersed before barrel 5. At barrel 5, a side stuffer introduced a wollastonite commercialized by NYCO as NYGLOS® 8 wollastonite, in the weight ratio specified in table 1 ; this one was metered into the side stuffer via a loss in weight feeder.

The wollastonite was distributed throughout the melted mixture in barrel 6 of the extruder. The new mixture was degassed via vacuum in barrel 7 of the extruder. That new mixture was compressed and cooled in barrel 8.

The thermal profile of the extruder was : no heat in barrel 1/330°C in barrels 2 to 5/315°C in barrel 6/300°C in barrel 7 and 285°C in barrel 8. The screw rate was 250 rpm.

The extrudate from barrel 8 was cooled and pelletized with conventional equipment.

Table 1

|  | Example E1 | Example E2 |
|---|---|---|
| *In barrel 1 :* | | |
| Polyterephthalamide of class (III) | 60.57 | 55.57 |
| Rutile titanium dioxide | 12 | 12 |
| KRATON® FG1901X olefin copolymer | 5 | 10 |
| Lube | 0.5 | 0.5 |
| Optical brightener | 0.03 | 0.03 |
| Antioxidant / heat stabilizer | 0.9 | 0.9 |
| *In barrel 5 (delayed addition) :* | | |
| Wollastonite | 21 | 21 |

Examples CE1 and CE2 (comparative compositions).

Example CE1 : it was proceeded exactly as for example E2 except that no KRATON® FG1901X olefin copolymer was introduced in the extruder ; said olefin copolymer was replaced weight pro weight by the polyterephalamide of class (III).

Example CE2 : it was proceeded exactly as for example 2 except that no wollastonite was introduced in the extruder ; said wollastonite was replaced weight pro weight by the polyterephthalamide of class (III).

Table 2

|  | Example CE1 | Example CE2 |
|---|---|---|
| *In barrel 1:* | | |
| Polyterephthlamide of class (III) | 65.57 | 76.57 |
| Rutile Titanium dioxide | 12 | 12 |
| KRATON® FG1901X olefin copolymer | --- | 10 |
| Lube | 0.5 | 0.5 |

(continued)

|  | Example CE1 | Example CE2 |
|---|---|---|
| Optical brightener | 0.03 | 0.03 |
| Antioxidant / heat stabilizer | 0.9 | 0.9 |
| *In barrel 5 (delayed addition) :* |  |  |
| Wollastonite | 21 | --- |

Examples E3 and E4 (compositions according to the invention).

For examples E3 and E4, it was proceeded exactly as for examples E1 and E2 respectively, except that a polyterephthalamide resin of class (IV), also commercially available from SOLVAY ADVANCED POLYMERS as AMODEL® polyphthalamide, was used instead of the polyterephalamide resin of class (III).

Examples CE3 and CE4 (comparative compositions).

Example CE3 : it was proceeded exactly as for example E4 except that no KRATON® FG1901X olefin copolymer was introduced in the extruder ; said olefin copolymer was replaced weight pro weight by the polyterephthalamide of class (IV).
Example CE4 : it was proceeded exactly as for example E4 except that no wollastonite was introduced in the extruder; said wollastonite was replaced weight pro weight by the polyterephthalamide of class (IV).
Compositions (E1), (E2), (E3) and (E4) (according to the invention) exhibited several beneficial properties over comparative compositions (CE1), (CE2), (CE3) and (CE4), and proved to be suitable for being profitably used for the manufacture of various articles, in particular LEDs.

Evaluation of polymer compositions.

REFLECTANCE.

Three polymer compositions were deeply assessed, namely E2 (according to the invention), CE1 and CE2 (as comparative compositions).
The reflectance of a material in the visible light spectrum (400-700 nm) is a very important, if not the most important, property of a material to be used for making conventional reflectors, the basic function of which is precisely to reflect the visible light.
The reflectance of a material depends on the wavelength at which it is measured. For the purpose of the present invention, the total reflectance of a material in the visible light spectrum, expressed in %, is intended to denote :

$$R_T = ( R_{420} + R_{440} + R_{460} + R_{480} + R_{500} + R_{520} + R_{540} + R_{560} + R_{580} + R_{600} + R_{620} + R_{640} + R_{660} + R_{680} + R_{700} ) : 15,$$

wherein $R_\lambda$ is the reflectance of the material at wavelength $\lambda$.
Of particular interest for reflector applications, is the reflectance of the material in the 420-520 nm wavelength region (because it corresponds to the blue region). The reflectance in this range can be quantified by :

$$R_{420-520} = ( R_{420} + R_{440} + R_{460} + R_{480} + R_{500} + R_{520} ) : 6 \text{ (expressed in %)},$$

$R_\lambda$ as above defined.

Initial reflectance (on unexposed samples).

Discs consisting of compositions E2, CE1 and CE2, having a diameter of 2 inches and a thickness of $1/8$ inch were molded using a Toyo 55T injection molding machine, with heater zones, from nozzle to feed, of respectively 640, 630, 620 and 605°F.

The reflectance of the discs at an incidence angle of 8° was measured as a function of wavelength (400-700 nm) using a BYK Gardner Color-Sphere spectrophotometer. As illuminant, the measurements used the D65 standard illuminant, which simulates daylight. As observer, the measurements used the 10° observer. The specular component of the reflection was included, but the UV portion of the spectrum was excluded. The measurements were done with the "large" measurement area (30 mm) and the "large" illumination area (36 mm).

The initial reflectance was measured on the discs as molded.

The results are presented in Table 3 herebelow.

Reflectance after concurrent exposure to heat and UV rays.

The discs were then concurrently exposed to 150°C and UV rays for 5 hours, using a Blue M oven of model ESP-400C-5 and a UVASPOT 400/T UV cure unit, commercially available from HONLE UV America Inc., equipped with a metal halide F-lamp as UV source. The oven was preheated at 150°C. The discs were placed at a distance of 14 cm from the UV source; no filter was used. The discs were rotated every hour so as to insure uniform exposure. After 5 h exposure, the discs were wrapped in tissue paper and submitted for reflectance testing.

The results are also presented in Table 3.

Reflectance results and comments.

Table 3. Initial reflectance measurements and reflectance after concurrent exposure to heat and UV rays

|  | Initial reflectance | | | Reflectance after concurrent exposure to heat and UV rays | | |
|---|---|---|---|---|---|---|
|  | CE2 | E2 | CE1 | CE2 | E2 | CE1 |
| $R_{400}$ (%) | 34 | 34 | 34 | 31 | 33 | 32 |
| $R_{420}$ (%) | 81 | 80 | 79 | 38 | 39 | 23 |
| $R_{440}$ (%) | 96 | 93 | 95 | 44 | 43 | 27 |
| $R_{460}$ (%) | 94 | 92 | 93 | 49 | 48 | 32 |
| $R_{480}$ (%) | 94 | 92 | 93 | 53 | 52 | 36 |
| $R_{500}$ (%) | 94 | 92 | 92 | 58 | 56 | 41 |
| $R_{520}$ (%) | 94 | 92 | 92 | 62 | 60 | 46 |
| $R_{540}$ (%) | 93 | 91 | 92 | 66 | 64 | 50 |
| $R_{560}$ (%) | 93 | 91 | 91 | 70 | 68 | 55 |
| $R_{580}$ (%) | 93 | 91 | 91 | 74 | 70 | 59 |
| $R_{600}$ (%) | 93 | 91 | 91 | 76 | 73 | 63 |
| $R_{620}$ (%) | 92 | 91 | 91 | 79 | 75 | 66 |
| $R_{640}$ (%) | 93 | 91 | 91 | 81 | 77 | 70 |
| $R_{660}$ (%) | 94 | 92 | 92 | 83 | 79 | 73 |
| $R_{680}$ (%) | 94 | 92 | 92 | 85 | 81 | 75 |
| $R_{700}$ (%) | 95 | 92 | 92 | 87 | 82 | 78 |
| $R_T$ (%) | 93 | 91 | 91 | 67 | 64 | 53 |
| $R_{420-520}$ (%) | 92 | 90 | 91 | 51 | 50 | 34 |

All the tested discs exhibited excellent (i.e. high) initial reflectance.

The discs made of CE2 and of E2, namely of the polyamide compositions that comprise the olefin copolymer, withstood the concurrent exposure to the heat and UV rays much better than the discs made of CE1 which is free of olefin copolymer. It was noted that the olefin copolymer was especially efficient for increasing the resistance to the concurrent exposure to the heat and the UV rays, as concerns the reflectance in the 420-520 nm area, which is of particular interest for reflector applications.

Thus, still another aspect of the present invention concerns a polymer composition comprising

- an aromatic polyamide,
- more than 5 wt. % (based on the total weight of the composition) of at least one crystalline silicate chosen from nesosilicates, sorosilicates, cyclosilicates, tectosilicates and inosilicates, and
- more than 2 wt. % (based on the total weight of the composition) of titanium dioxide,

which, if concurrently exposed to heat and UV rays at 150°C for 5 hours, using a Blue M oven of model ESP-400C-5 and a UVASPOT 400/T UV cure unit, equipped with a metal halide F-lamp as UV source, with a UV source-composition distance of 14 cm and absent any filter, has a total reflectance in the visible light spectrum $R_T$ of above 55 %, wherein $R_T$ is calculated by number-averaging the reflectances $R_\lambda$ in the visible light spectrum, said reflectances $R_\lambda$ being measured at an incidence angle of 8° using a BYK Gardner Color-Sphere spectrophotometer, a D65 standard illuminant and a 10° observer.

A last aspect of the present invention concerns a polymer composition comprising

- an aromatic polyamide,
- more than 5 wt. % (based on the total weight of the composition) of at least one crystalline silicate chosen from nesosilicates, sorosilicates, cyclosilicates, tectosilicates and inosilicates, and
- more than 2 wt. % (based on the total weight of the composition) of titanium dioxide,

which, if concurrently exposed to heat and UV rays at 150°C for 5 hours, using a Blue M oven of model ESP-400C-5 and a UVASPOT 400/T UV cure unit, equipped with a metal halide F-lamp as UV source, with a UV source-composition distance of 14 cm and absent any filter, has a reflectance in the 420-520 nm wavelength region $R_{420\text{-}520}$ of above 40 %, and preferably above 45 %, wherein $R_{420\text{-}520}$ is calculated by number-averaging the reflectances $R_\lambda$ in the 420-520 nm wavelength region, said reflectances $R_\lambda$ being measured at an incidence angle of 8° using a BYK Gardner Color-Sphere spectrophotometer, a D65 standard illuminant and a 10° observer.

## OTHER PROPERTIES.

Other properties than the reflectance were assessed, namely the tensile strength, the tensile modulus, the heat deflection temperature, and the IZOD impact value.

Specimens made of compositions CE1 and of E2, namely the specimens made of the polyamide compositions that comprise the wollastonite, exhibited an increased tensile strength and an increased tensile modulus, when compared to specimens made of CE2 which is free of wollastonite.

Specimens made of compositions CE1 and of E2 exhibited further an increased heat deflection temperature, when compared to specimens made of CE2 which is free of wollastonite.

Notably because of its low tensile strength, its low tensile modulus and its low heat deflection temperature, composition CE2 is usually not suitable for making LED reflectors.

Besides, specimens made of compositions CE2 and E2, namely the specimens made of the polyamide compositions that comprise the olefin copolymer, exhibited an increased IZOD impact value when compared to specimens made of CE2 which is free of olefin copolymer.

## Claims

1. Polymer composition comprising

    - an aromatic polyamide,
    - more than 5 wt. % (based on the total weight of the composition) of at least one crystalline silicate chosen from nesosilicates, sorosilicates, cyclosilicates, tectosilicates and inosilicates,
    - more than 2 wt. % (based on the total weight of the composition) of titanium dioxide, and
    - more than 1 wt. % (based on the total weight of the composition) of at least one optionally functionalized olefin copolymer.

2. Polymer composition according to claim 1, **characterized in that** it comprises above 8 wt. % (based on the total weight of the polymer composition) of titanium dioxide.

3. Polymer composition according to anyone of the preceding claims, **characterized in that** it further comprises more than 0.003 wt. % (based on the total weight of the composition) of at least one optical brightener.

4. Polymer composition comprising

   - an aromatic polyamide,
   - more than 5 wt. % (based on the total weight of the composition) of at least one crystalline silicate chosen from nesosilicates, sorosilicates, cyclosilicates, tectosilicates and inosilicates,
   - more than 0.003 wt. % (based on the total weight of the composition) of at least one optical brightener, and
   - more than 1 wt. % (based on the total weight of the composition) of at least one optionally functionalized olefin copolymer.

5. Polymer composition according to claim 3 or 4, **characterized in that** the optical brightener is 4,4'-bis(2-benzoxazolyl)stilbene.

6. Polymer composition according to anyone of claims 3 to 5, **characterized in that** it comprises above 0.020 wt. % (based on the total weight of the polymer composition) of the optical brightener.

7. Polymer composition according to anyone of the preceding claims, **characterized in that** the aromatic polyamide is a polyterephthalamide.

8. Polymer composition according to anyone of the preceding claims, **characterized in that** the aromatic polyamide is contained in the polymer composition in an amount of more than 50 % by weight (based on the total weight of the polymer composition).

9. Polymer composition according to anyone of the preceding claims, **characterized in that** the crystalline silicate is wollastonite.

10. Polymer composition according to anyone of the preceding claims, **characterized in that** the crystalline silicate consists of particles having a number-average aspect ratio $\alpha$ of above 10.

11. Polymer composition according to anyone of the preceding claims, **characterized in that** the crystalline silicate is contained in the polymer composition in an amount of more than 15 % by weight (based on the total weight of the polymer composition).

12. Polymer composition according to anyone of the preceding claims, **characterized in that** the optionally functionalized olefin copolymer is chosen from optionally functionalized styrene-monoolefin block copolymers and optionally functionalized styrene-diolefins block polymers.

13. Polymer composition according to anyone of the preceding claims, **characterized in that** the optionally functionalized olefin copolymer has at least one glass transition temperature (measured by DSC during the second heat with a slope of 10°C/min) lower than - 20 °C.

14. Polymer composition according to anyone of the preceding claims, **characterized in that** the optionally functionalized olefin copolymer is a functionalized, said functionalisation being achieved by grafting at least one ethylenically unsaturated monomer bearing carboxyl groups.

15. Polymer composition according to anyone of the preceding claims, **characterized in that** the optionally functionalized olefin copolymer is contained in the polymer composition in an amount of more than 3 % by weight (based on the total weight of the polymer composition).

16. Polymer composition according to claim 15, **characterized in that** the optionally functionalized olefin copolymer is contained in the polymer composition in an amount of more than 6 % by weight (based on the total weight of the polymer composition).

17. Polymer composition according to anyone of the preceding claims, **characterized in that** the optionally functionalized olefin copolymer is contained in the polymer composition in an amount of less than 15 % by weight (based on the total weight of the polymer composition).

18. Polymer composition according to anyone of claims 1 to 17, **characterized in that**, if concurrently exposed to heat and UV rays at 150°C for 5 hours, using a Blue M oven of model ESP-400C-5 and a UVASPOT 400/T UV cure unit, equipped with a metal halide F-lamp as UV source, with a UV source-composition distance of 14 cm and absent any filter, has a total reflectance in the visible light spectrum $R_T$ of above 55 %, wherein $R_T$ is calculated by number-averaging the reflectances $R_\lambda$ in the visible light spectrum, said reflectances $R_\lambda$ being measured at an incidence angle of 8° using a BYK Gardner Color-Sphere spectrophotometer, a D65 standard illuminant and a 10° observer.

19. Polymer composition according to anyone to claims 1 to 17, **characterized in that**, if concurrently exposed to heat and UV rays at 150°C for 5 hours, using a Blue M oven of model ESP-400C-5 and a UVASPOT 400/T UV cure unit, equipped with a metal halide F-lamp as UV source, with a UV source-composition distance of 14 cm and absent any filter, has a reflectance in the 420-520 nm wavelength region $R_{420\text{-}520}$ of above 40 %, wherein $R_{420\text{-}520}$ is calculated by number-averaging the reflectances $R_\lambda$ in the 420-520 nm wavelength region, said reflectances $R_\lambda$ being measured at an incidence angle of 8° using a BYK Gardner Color-Sphere spectrophotometer, a D65 standard illuminant and a 10° observer.

20. Article comprising the polymer composition according to anyone of claims 1 to 17.

21. Article according to claim 20, **characterized in that** it is an electro-optical components.

22. Article according to claim 21, **characterized in that** it is a LED.

23. Part susceptible of acting as a reflector in a light emission apparatus, said part comprising the polymer composition according to anyone of claims 1 to 17.

24. Part according to claim 23, **characterized in that** it is the basic housing of a LED.

25. Part according to claim 23, **characterized in that** it is the heatsink slug of a LED.

26. Use of at least one optionally functionalized olefin copolymer as an additive of a polymer composition comprising an aromatic polyamide to increase the UV resistance of the polymer composition.

27. Use of at least one optionally functionalized olefin copolymer as an additive of a polymer composition comprising an aromatic polyamide to increase the UV resistance of an article comprising the polymer composition.

28. Use of at least one optionally functionalized olefin copolymer as an additive of a polymer composition comprising an aromatic polyamide to increase the UV resistance of a part susceptible of acting as a reflector in a light emission apparatus, said part comprising the polymer composition.

29. Use according to anyone of claims 26 to 28, **characterized in that** the optionally functionalized olefin copolymer is used to increase the resistance of the polymer composition to a concurrent exposure to heat and UV rays.

30. Use according to anyone of claims 26 to 29, **characterized in that** the polymer composition is a polymer composition according to anyone of claims 1 to 17.

**Patentansprüche**

1. Polymerzusammensetzung, umfassend :

   - ein aromatisches Polyamid,
   - mehr als 5 Gew.-% (bezogen auf das Gesamtgewicht der Zusammensetzung) mindestens eines kristallinen Silicats, das unter Nesosilicaten, Sorosilicaten, Cyclosilicaten, Tectosilicaten und Inosilicaten ausgewählt ist,
   - mehr als 2 Gew.-% (bezogen auf das Gesamtgewicht der Zusammensetzung) Titandioxid und
   - mehr als 1 Gew.-% (bezogen auf das Gesamtgewicht der Zusammensetzung) mindestens eines gegebenenfalls funktionalisierten Olefincopolymers.

2. Polymerzusammensetzung nach Anspruch 1, **dadurch gekennzeichnet, dass** sie über 8 Gew.-% (bezogen auf das Gesamtgewicht der Polymerzusammensetzung) Titandioxid umfasst.

3. Polymerzusammensetzung nach einem der vorhergehenden Ansprüche, **dadurch gekennzeichnet, dass** sie ferner mehr als 0,003 Gew.-% (bezogen auf das Gesamtgewicht der Zusammensetzung) mindestens eines optischen Aufhellers umfasst.

4. Polymerzusammensetzung, umfassend :

   - ein aromatisches Polyamid,
   - mehr als 5 Gew.-% (bezogen auf das Gesamtgewicht der Zusammensetzung) mindestens eines kristallinen Silicats, das unter Nesosilicaten, Sorosilicaten, Cyclosilicaten, Tectosilicaten und Inosilicaten ausgewählt ist,
   - mehr als 0,003 Gew.-% (bezogen auf das Gesamtgewicht der Zusammensetzung) mindestens eines optischen Aufhellers und
   - mehr als 1 Gew.-% (bezogen auf das Gesamtgewicht der Zusammensetzung) mindestens eines gegebenenfalls funktionalisierten Olefincopolymers.

5. Polymerzusammensetzung nach Anspruch 3 oder 4, **dadurch gekennzeichnet, dass** es sich bei dem optischen Aufheller um 4,4'-Bis(2-benzoxazolyl)stilben handelt.

6. Polymerzusammensetzung nach einem der Ansprüche 3 bis 5, **dadurch gekennzeichnet, dass** sie über 0,020 Gew.-% (bezogen auf das Gesamtgewicht der Polymerzusammensetzung) des optischen Aufhellers umfasst.

7. Polymerzusammensetzung nach einem der vorhergehenden Ansprüche, **dadurch gekennzeichnet, dass** es sich bei dem aromatischen Polyamid um ein Polyterephthalamid handelt.

8. Polymerzusammensetzung nach einem der vorhergehenden Ansprüche, **dadurch gekennzeichnet, dass** das aromatische Polyamid in der Polymerzusammensetzung in einer Menge von mehr als 50 Gew.-% (bezogen auf das Gesamtgewicht der Polymerzusammensetzung) enthalten ist.

9. Polymerzusammensetzung nach einem der vorhergehenden Ansprüche, **dadurch gekennzeichnet, dass** es sich bei dem kristallinen Silicat um Wollastonit handelt.

10. Polymerzusammensetzung nach einem der vorhergehenden Ansprüche, **dadurch gekennzeichnet, dass** das kristalline Silicat aus Teilchen mit einem zahlenmittleren Aspektverhältnis $\alpha$ über 10 besteht.

11. Polymerzusammensetzung nach einem der vorhergehenden Ansprüche, **dadurch gekennzeichnet, dass** das kristalline Silicat in der Polymerzusammensetzung in einer Menge von mehr als 15 Gew.-% (bezogen auf das Gesamtgewicht der Polymerzusammensetzung) enthalten ist.

12. Polymerzusammensetzung nach einem der vorhergehenden Ansprüche, **dadurch gekennzeichnet, dass** das gegebenenfalls funktionalisierte Olefincopolymer unter gegebenenfalls funktionalisierten Styrol-Monoolefin-Blockcopolymeren und gegebenenfalls funktionalisierten Styrol-Diolefin-Blockcopolymeren ausgewählt ist.

13. Polymerzusammensetzung nach einem der vorhergehenden Ansprüche, **dadurch gekennzeichnet, dass** das gegebenenfalls funktionalisierte Olefincopolymer mindestens eine Glasübergangstemperatur (gemessen mittels DSC beim zweiten Erhitzen mit einer Rate von 10°C/min) von weniger als -20°C aufweist.

14. Polymerzusammensetzung nach einem der vorhergehenden Ansprüche, **dadurch gekennzeichnet, dass** das gegebenenfalls funktionalisierte Olefincopolymer funktionalisiert ist, wobei die Funktionalisierung durch Aufpfropfen mindestens eines ethylenisch ungesättigten Monomers mit Carboxylgruppen erreicht wird.

15. Polymerzusammensetzung nach einem der vorhergehenden Ansprüche, **dadurch gekennzeichnet, dass** das gegebenenfalls funktionalisierte Olefincopolymer in der Polymerzusammensetzung in einer Menge von mehr als 3 Gew.-% (bezogen auf das Gesamtgewicht der Polymerzusammensetzung) enthalten ist.

16. Polymerzusammensetzung nach Anspruch 15, **dadurch gekennzeichnet, dass** das gegebenenfalls funktionalisierte Olefincopolymer in der Polymerzusammensetzung in einer Menge von mehr als 6 Gew.-% (bezogen auf das Gesamtgewicht der Polymerzusammensetzung) enthalten ist.

17. Polymerzusammensetzung nach einem der vorhergehenden Ansprüche, **dadurch gekennzeichnet, dass** das

17

gegebenenfalls funktionalisierte Olefincopolymer in der Polymerzusammensetzung in einer Menge von weniger als 15 Gew.-% (bezogen auf das Gesamtgewicht der Polymerzusammensetzung) enthalten ist.

18. Polymerzusammensetzung nach einem der Ansprüche 1 bis 17, **dadurch gekennzeichnet, dass** sie bei gleichzeitiger Einwirkung von Wärme und UV-Strahlen bei 150°C über einen Zeitraum von 5 Stunden unter Verwendung eines Blue-M-Ofens Modell ESP-400C-5 und einer UVASPOT-400/T-UV-Härtungseinheit mit einer Metallhalogenid-F-Lampe als UV-Quelle bei einem Abstand zwischen UV-Quelle und Zusammensetzung von 14 cm und ohne jegliches Filter einen Gesamtreflexionsgrad im Spektrum des sichtbaren Lichts $R_T$ von über 55% aufweist, wobei $R_T$ durch Zahlenmittelung der Reflexionsgrade $R_\lambda$ im Spektrum des sichtbaren Lichts berechnet wird, wobei die Reflexionsgrade $R_\lambda$ bei einem Einfallswinkel von 8° unter Verwendung eines Color-Sphere-Spektralphotometers von BYK Gardner, einer D65-Normlichtquelle und einem 10°-Beobachter gemessen werden.

19. Polymerzusammensetzung nach einem der Ansprüche 1 bis 17, **dadurch gekennzeichnet, dass** sie bei gleichzeitiger Einwirkung von Wärme und UV-Strahlen bei 150°C über einen Zeitraum von 5 Stunden unter Verwendung eines Blue-M-Ofens Modell ESP-400C-5 und einer UVASPOT-400/T-UV-Härtungseinheit mit einer Metallhalogenid-F-Lampe als UV-Quelle bei einem Abstand zwischen UV-Quelle und Zusammensetzung von 14 cm und ohne jegliches Filter einen Reflexionsgrad im Wellenlängenbereich von 420-520 nm $R_{420-520}$ von über 40% aufweist, wobei $R_{420-520}$ durch Zahlenmittelung der Reflexionsgrade $R_\lambda$ im Wellenlängenbereich von 420-520 nm berechnet wird, wobei die Reflexionsgrade $R_\lambda$ bei einem Einfallswinkel von 8° unter Verwendung eines Color-Sphere-Spektralphotometers von BYK Gardner, einer D65-Normlichtquelle und einem 10°-Beobachter gemessen werden.

20. Gegenstand, umfassend die Polymerzusammensetzung nach einem der Ansprüche 1 bis 17.

21. Gegenstand nach Anspruch 20, **dadurch gekennzeichnet, dass** es sich um ein elektrooptisches Bauteil handelt.

22. Gegenstand nach Anspruch 21, **dadurch gekennzeichnet, dass** es sich um eine LED handelt.

23. Teil, das als Reflektor in einer Lichtemissionsapparatur fungieren kann, wobei das Teil die Polymerzusammensetzung nach einem der Ansprüche 1 bis 17 umfasst.

24. Teil nach Anspruch 23, **dadurch gekennzeichnet, dass** es sich um das Grundgehäuse einer LED handelt.

25. Teil nach Anspruch 23, **dadurch gekennzeichnet, dass** es sich um den Wärmeverteiler einer LED handelt.

26. Verwendung mindestens eines gegebenenfalls funktionalisierten Olefincopolymers als Additiv einer Polymerzusammensetzung, die ein aromatisches Polyamid umfasst, zur Erhöhung der UV-Beständigkeit der Polymerzusammensetzung.

27. Verwendung mindestens eines gegebenenfalls funktionalisierten Olefincopolymers als Additiv einer Polymerzusammensetzung, die ein aromatisches Polyamid umfasst, zur Erhöhung der UV-Beständigkeit eines Artikels, der die Polymerzusammensetzung umfasst.

28. Verwendung mindestens eines gegebenenfalls funktionalisierten Olefincopolymers als Additiv einer Polymerzusammensetzung, die ein aromatisches Polyamid umfasst, zur Erhöhung der UV-Beständigkeit eines Teils, das als Reflektor in einer Lichtemissionsapparatur fungieren kann, wobei das Teil die Polymerzusammensetzung umfasst.

29. Verwendung nach einem der Ansprüche 26 bis 28, **dadurch gekennzeichnet, dass** das gegebenenfalls funktionalisierte Olefincopolymer zur Erhöhung der Beständigkeit der Polymerzusammensetzung gegenüber gleichzeitiger Einwirkung von Wärme und UV-Strahlen verwendet wird.

30. Verwendung nach einem der Ansprüche 26 bis 29, **dadurch gekennzeichnet, dass** es sich bei der Polymerzusammensetzung um eine Polymerzusammensetzung nach einem der Ansprüche 1 bis 17 handelt.

**Revendications**

1. Composition de polymère comprenant

   - un polyamide aromatique,
   - plus de 5 % en poids (par rapport au poids total de la composition) d'au moins un silicate cristallin choisi parmi les nésosilicates, les sorosilicates, les cyclosilicates, les tectosilicates et les inosilicates,
   - plus de 2 % en poids (par rapport au poids total de la composition) de dioxyde de titane, et
   - plus de 1 % en poids (par rapport au poids total de la composition) d'au moins un copolymère d'oléfine éventuellement fonctionnalisé.

2. Composition de polymère selon la revendication 1, **caractérisée en ce qu'**elle comprend plus de 8 % en poids (par rapport au poids total de la composition de polymère) de dioxyde de titane.

3. Composition de polymère selon l'une quelconque des revendications précédentes, **caractérisée en ce qu'**elle comprend en outre plus de 0,003 % en poids (par rapport au poids total de la composition) d'au moins un azurant optique.

4. Composition de polymère comprenant

   - un polyamide aromatique,
   - plus de 5 % en poids (par rapport au poids total de la composition) d'au moins un silicate cristallin choisi parmi les nésosilicates, les sorosilicates, les cyclosilicates, les tectosilicates et les inosilicates,
   - plus de 0,003 % en poids (par rapport au poids total de la composition) d'au moins un azurant optique, et
   - plus de 1 % en poids (par rapport au poids total de la composition) d'au moins un copolymère d'oléfine éventuellement fonctionnalisé.

5. Composition de polymère selon la revendication 3 ou 4, **caractérisée en ce que** l'azurant optique est le 4,4'-bis(2-benzoxazolyl)stilbène.

6. Composition de polymère selon l'une quelconque des revendications 3 à 5, **caractérisée en ce qu'**elle comprend plus de 0,020 % en poids (par rapport au poids total de la composition de polymère) de l'azurant optique.

7. Composition de polymère selon l'une quelconque des revendications précédentes, **caractérisée en ce que** le polyamide aromatique est un polytéréphtalamide.

8. Composition de polymère selon l'une quelconque des revendications précédentes, **caractérisée en ce que** le polyamide aromatique est contenu dans la composition de polymère en quantité de plus de 50 % en poids (par rapport au poids total de la composition de polymère).

9. Composition de polymère selon l'une quelconque des revendications précédentes, **caractérisée en ce que** le silicate cristallin est la wollastonite.

10. Composition de polymère selon l'une quelconque des revendications précédentes, **caractérisée en ce que** le silicate cristallin est constitué de particules présentant un rapport d'aspect moyen en nombre $\alpha$ supérieur à 10.

11. Composition de polymère selon l'une quelconque des revendications précédentes, **caractérisée en ce que** le silicate cristallin est contenu dans la composition de polymère en quantité de plus de 15 % en poids (par rapport au poids total de la composition de polymère).

12. Composition de polymère selon l'une quelconque des revendications précédentes, **caractérisée en ce que** le copolymère d'oléfine éventuellement fonctionnalisé est choisi parmi les copolymères séquencés styrène-monooléfine éventuellement fonctionnalisés et les polymères séquencés styrène-dioléfines éventuellement fonctionnalisés.

13. Composition de polymère selon l'une quelconque des revendications précédentes, **caractérisée en ce que** le copolymère d'oléfine éventuellement fonctionnalisé présente au moins une température de transition vitreuse (mesurée par DSC au cours de la deuxième montée en température avec une pente de 10°C/min) inférieure à -20°C.

**14.** Composition de polymère selon l'une quelconque des revendications précédentes, **caractérisée en ce que** le copolymère d'oléfine éventuellement fonctionnalisé est fonctionnalisé, ladite fonctionnalisation étant réalisée par greffage d'au moins un monomère à insaturation éthylénique portant des groupes carboxyle.

**15.** Composition de polymère selon l'une quelconque des revendications précédentes, **caractérisée en ce que** le copolymère d'oléfine éventuellement fonctionnalisé est contenu dans la composition de polymère en quantité de plus de 3 % en poids (par rapport au poids total de la composition de polymère).

**16.** Composition de polymère selon la revendication 15, **caractérisée en ce que** le copolymère d'oléfine éventuellement fonctionnalisé est contenu dans la composition de polymère en quantité de plus de 6 % en poids (par rapport au poids total de la composition de polymère).

**17.** Composition de polymère selon l'une quelconque des revendications précédentes, **caractérisée en ce que** le copolymère d'oléfine éventuellement fonctionnalisé est contenu dans la composition de polymère en quantité de moins de 15 % en poids (par rapport au poids total de la composition de polymère).

**18.** Composition de polymère selon l'une quelconque des revendications 1 à 17, **caractérisée en ce que**, si elle est exposée en même temps à de la chaleur et à des rayons UV à 150°C pendant 5 heures, au moyen d'un four Blue M de modèle ESP-400C-5 et d'une unité de durcissement UV UVASPOT 400/T, équipée d'une lampe F aux halogénures métalliques en tant que source d'UV, avec une distance entre la source d'UV et la composition de 14 cm et sans aucun filtre, elle présente une réflectance totale dans le spectre de lumière visible $R_T$ supérieure à 55 %, $R_T$ étant calculée par la moyenne en nombre des réflectances $R_\lambda$ dans le spectre de lumière visible, lesdites réflectances $R_\lambda$ étant mesurées à un angle incident de 8° au moyen d'un spectrophotomètre BYK Gardner Color-Sphere, d'un illuminant étalon D65 et d'un observateur à 10°.

**19.** Composition de polymère selon l'une quelconque des revendications 1 à 17, **caractérisée en ce que**, si elle est exposée en même temps à de la chaleur et à des rayons UV à 150°C pendant 5 heures, au moyen d'un four Blue M de modèle ESP-400C-5 et d'une unité de durcissement UV UVASPOT 400/T, équipée d'une lampe F aux halogénures métalliques en tant que source d'UV, avec une distance entre la source d'UV et la composition de 14 cm et sans aucun filtre, elle présente un réflectance, dans le domaine de longueurs d'onde de 420-520 nm, $R_{420-S20}$ supérieure à 40 %, $R_{420-520}$ étant calculée par la moyenne en nombre des réflectances $R_\lambda$ dans le domaine de longueurs d'onde de 420-520 nm, lesdites réflectances $R_\lambda$ étant mesurées à un angle incident de 8° au moyen d'un spectrophotomètre BYK Gardner Color-Sphere, d'un illuminant étalon D65 et d'un observateur à 10°.

**20.** Article comprenant la composition de polymère selon l'une quelconque des revendications 1 à 17.

**21.** Article selon la revendication 20, **caractérisé en ce qu'**il est un composant électro-optique.

**22.** Article selon la revendication 21, **caractérisé en ce qu'**il est une LED.

**23.** Pièce susceptible de faire office de réflecteur dans un appareil émettant de la lumière, ladite pièce comprenant la composition de polymère selon l'une quelconque des revendications 1 à 17.

**24.** Pièce selon la revendication 23, **caractérisée en ce qu'**elle est le boîtier de base d'une LED.

**25.** Pièce selon la revendication 23, **caractérisée en ce qu'**elle est le pad du dissipateur thermique d'une LED.

**26.** Utilisation d'au moins un copolymère d'oléfine éventuellement fonctionnalisé en tant qu'additif d'une composition de polymère comprenant un polyamide aromatique pour augmenter la résistance aux UV de la composition de polymère.

**27.** Utilisation d'au moins un copolymère d'oléfine éventuellement fonctionnalisé en tant qu'additif d'une composition de polymère comprenant un polyamide aromatique pour augmenter la résistance aux UV d'un article comprenant la composition de polymère.

**28.** Utilisation d'au moins un copolymère d'oléfine éventuellement fonctionnalisé en tant qu'additif d'une composition de polymère comprenant un polyamide aromatique pour augmenter la résistance aux UV d'une pièce susceptible de faire office de réflecteur dans un appareil émettant de la lumière, ladite pièce comprenant la composition de polymère.

**29.** Utilisation selon l'une quelconque des revendications 26 à 28, **caractérisée en ce que** le copolymère d'oléfine éventuellement fonctionnalisé est utilisé pour augmenter la résistance de la composition de polymère à une exposition simultanée à de la chaleur et à des rayons UV.

**30.** Utilisation selon l'une quelconque des revendications 26 à 29, **caractérisée en ce que** la composition de polymère est une composition de polymère selon l'une quelconque des revendications 1 à 17.

Figure 1

Figure 2

Figure 3

Figure 4

Figure 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1466944 A